Europäisches Patentamt

European Patent Office

Office européen des brevets

(11) Publication number: **0 072 082**
**B1**

(12) # EUROPEAN PATENT SPECIFICATION

(45) Date of publication of patent specification: **03.07.85**

(51) Int. Cl.⁴: **H 03 F 3/45**

(21) Application number: **82301339.6**

(22) Date of filing: **16.03.82**

(54) **Differential amplifier circuit with precision active load.**

(30) Priority: **06.08.81 US 290418**

(43) Date of publication of application:
**16.02.83 Bulletin 83/07**

(45) Publication of the grant of the patent:
**03.07.85 Bulletin 85/27**

(84) Designated Contracting States:
**AT BE CH DE FR GB IT LI LU NL SE**

(56) References cited:
**DE-A-1 966 421**
**DE-A-2 358 471**
**DE-A-2 520 890**
**DE-A-2 828 147**
**DE-B-2 322 466**
**DE-B-2 337 138**
**US-A-3 786 362**

(73) Proprietor: **PRECISION MONOLITHICS INC.**
**1500 Space Park Drive**
**Santa Clara California 95050 (US)**

(72) Inventor: **Nishikawa, Yukio**
**15311 Francis Oaks Way**
**Los Gatos California (US)**
Inventor: **Fukahori, Kiyoshi**
**2342 Price Way**
**San Jose California 95124 (US)**

(74) Representative: **Crawford, Andrew Birkby et al**
**A.A. THORNTON & CO. Northumberland House**
**303-306 High Holborn**
**London WC1V 7LE (GB)**

Courier Press, Leamington Spa, England.

EP 0 072 082 B1

## Description

This invention relates to electronic amplifier circuitry, and more particularly to a differential amplifier circuit with an active load for reducing amplifier offset voltages.

Differential amplifiers are used to amplify differences in potential between two inputs. They have typically been used in conjunction with load circuits having active semiconductor elements, such as transistors. It has been found, however, that an active load inherently introduces errors in the amplifier output, due to the fact that both the current gain of the load transistor and the output impedance of the load circuit are finite, rather than infinite as in an idealized circuit. These errors appear as an offset voltage when referred back to the amplifier input. The offset voltage is defined as that voltage which must be applied to the amplifier input to force the output to zero or a nominal value. Depending on the values of the transistor gains and output impedances, and on how the active load is sensed, the magnitude of the offset voltage is typically in the range of 100 microvolts to several millivolts, or greater.

In the ideal differential amplifier, both the voltages within and the currents through each branch of the amplifier are balanced, and are equal to each other when the same input voltage is applied to both branches of the amplifier. The introduction of an active load circuit with finite current gain and finite output impedance can cause imbalances of both branch voltages and branch currents. Previous attempts to reduce these errors have tended to make the circuitry more complex, have reduced the effective amplifier gain, and have failed to solve both the current and voltage imbalances. Furthermore, some of the prior art circuits have introduced a second mirror pole, the effect of which has been to seriously limit the bandwidth of the amplifier.

GB 2000930A discloses (Fig. 4) a differential amplifier which utilizes a primary load circuit and a secondary load circuit in an attempt to overcome the above problems.

In view of the above problems associated with the prior art, it is the object of the present invention to provide a differential amplifier with an active load circuit that substantially reduces the input offset voltage, corrects for both voltage and current imbalances that would otherwise be introduced by an active load circuit, has a high gain, does not unduly complicate the circuitry, and avoids the addition of a second mirror pole.

The present invention provides a differential amplifier circuit, with a precision active load for correcting input voltage offsets, comprising: a differential amplifier having first and second input means connected respectively to first and second amplifier branches; a primary load circuit connected to a voltage supply and including at least a first and a second transistor means connected to provide primary load currents respectively to said first and second amplifier branches; and a secondary load circuit connected to the voltage source and to the second amplifier branch, characterised in that said primary load currents are mutually unbalanced by a current having components proportional to the inverse of the first and second power of transistor current gain, said primary load circuit providing a multi-junction path between the voltage source and the first amplifier branch to clamp the voltage level of said branch with respect to the source; and in that said secondary load circuit is connected to the voltage source and to the second amplifier branch to substantially balance the currents in the two amplifier branches, said secondary load circuit including at least a third and fourth transistor means matched with the respective first and second transistor means of the primary load circuit, and connected to provide a balancing current having components proportional to the inverse of the first and second power of transistor current gain to the second amplifier branch, said secondary load circuit being further connected to provide a multi-junction path between the voltage source and the second amplifier branch to substantially balance the voltage levels of the two amplifier branches, whereby the input voltage offset is a function of no more than the inverse of the third power of transistor current gain.

The primary circuit provides a multi-junction path between one of the amplifier branches and a voltage supply, while the secondary circuit provides a matched multi-junction path between the other amplifier branch and the voltage supply, thereby clamping the two branches at substantially balanced voltage levels. Currents through the matched portions of the two multi-junction paths are set up equally to establish substantially equal junction voltage drops.

In the preferred embodiment, the primary load circuit comprises first and second current mirrors. The first current mirror provides a current to the second current mirror which has components proportional to the zero and inverse of the first power of transistor current gain, while the second current mirror provides primary currents to the amplifier branches which are mutually unbalanced by an amount proportional to the inverse of the first and second power of transistor current gain. The secondary circuit provides a balancing current to one of the amplifier branches, which current also has components proportional to the inverse of the first and second power of transistor current gain, and is matched with the difference between the primary currents. The resulting current differential between the two branches is accordingly very small. The secondary circuit device which provides the correction current is also preferably clamped to the voltage supply.

In a particularly implementation of the invention, the first and second current mirrors comprise first and second junction transistors having dual matched terminals in their collector-emitter circuits. One of the dual terminals of the first transistor is connected with its base terminal to provide current to the second transistor. The second transistor in turn has its dual terminals connected to supply current to the two amplifier branches, respectively, one of its dual terminals also being connected to its base terminal. The secondary circuit consists of third and fourth junction transistors matched respectively with the first and second junction transistors. The base of the third transistor, together with the other dual terminal of the first transistor, are connected as inputs to the fourth transistor, the base of which supplies balancing current to one of the amplifier branches. The first and third transistors are clamped to a voltage supply, and the fourth transistor is also clamped to the voltage supply through a pair of diode-connected transistors, thereby balancing the amplifier branch voltages.

These and other features and advantages of the invention will become apparent to one skilled in the art from the following detailed description, taken together with the accompanying drawings, in which:

Figure 1 is a circuit diagram of a prior art differential amplifier with an uncorrected active load circuit;

Figures 2—4 are circuit diagrams of various prior art circuits which partially correct the input voltage offset produced by the load circuit shown in Figure 1; and

Figure 5 is a circuit diagram of a differential amplifier with a precision active load circuit constructed in accordance with the present invention.

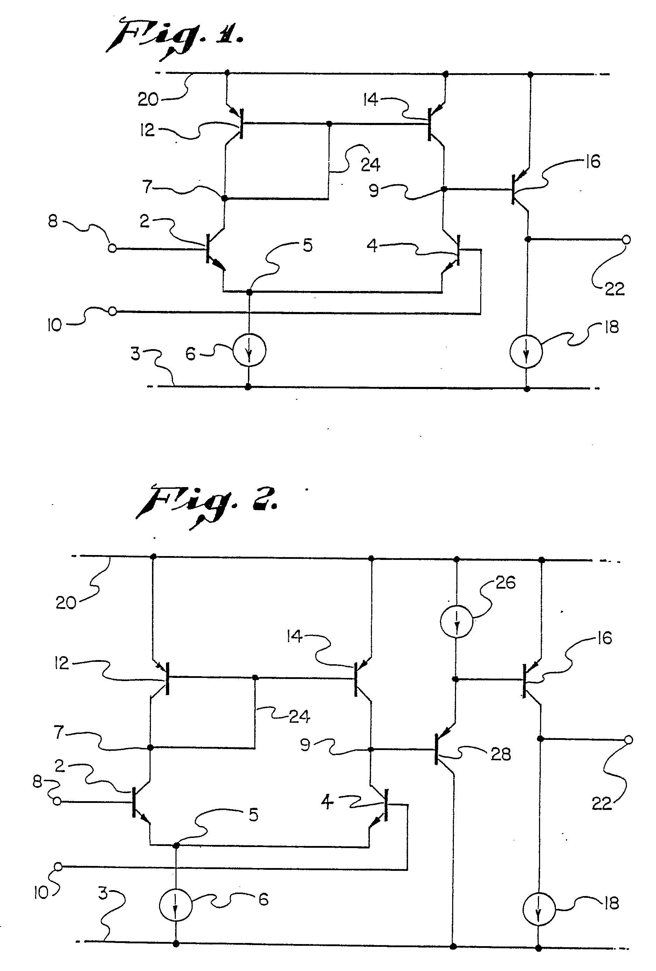

Referring first to Figure 1, a differential amplifier is shown with a prior art active load circuit that produces a significant input voltage offset. The amplifier is formed by a pair of NPN transistors 2 and 4 having their emitters connected to a current source 6 at node 5, and their bases connected respectively to input terminals 8 and 10. The circuit through transistor 2 forms one branch of the differential amplifier, while the circuit through transistor 4 forms the other branch. The active load circuit consists of PNP transistors 12 and 14. The emitters of transistors 12 and 14 are connected to a positive voltage line 20, while their bases are connected together and are connected to the collectors of transistors 2 and 12 by line 24 at node 7. The collectors of transistors 4 and 14 are connected together and to the base of a PNP transistor 16 at node 9. The emitter of transistor 16 is also connected to positive voltage line 20. The collector of transistor 16 is connected to current source 18, which arrangement forms the second gain stage for the amplifier with the output at collector terminal 11. Both current sources 6 and 18 are connected to a negative voltage line 3.

With the circuit as shown, the base currents of transistors 12 and 14 are both delivered over line 24 from the base connection to the left hand amplifier branch. The resulting double base current imbalance is not compensated by the single base current delivered to the right hand amplifier branch from transistor 16, and as a result the two branch currents are out of balance. By setting current source 18 to conduct twice the current of current source 6, the base current from transistor 16 approaches that through line 24. This results in the branch currents approaching balance. However, the differential amplifier gain is low because the impedance at node 9 is primarily determined by the current gain of transistor 16 multiplied by its emitter to base dynamic resistance ($r_e$).

One prior art attempt to correct the low gain problem is shown in the modified circuit of Figure 2, in which corresponding elements are identified by the same reference numerals as in Figure 1. In this circuit, an additional current source 26 is connected to the emitter of a transistor 28 whose base is connected to the right hand branch of the differential amplifier at node 9. The base of the second gain stage transistor 16 is connected to the emitter of transistor 28, rather than to node 9 as in the prior circuit. The value of current source 26 is selected such that, when combined with the base current from transistor 16, the current through the emitter-collector circuit of transistor 28 produces a base current from that transistor sufficient to compensate for the current imbalance between the two branches of the differential amplifier.

While substantially increasing the gain, since the impedance at node 9 has been raised to the square of the current gain multiplied by the $r_e$ of transistor 16, the circuit of Figure 2 introduces a voltage imbalance between the two branches. This results from the left hand branch being connected to voltage line 20 through the single base-emitter junction voltage of transistors 12 and 14, while the right hand branch at the collector of transistor 4 is connected to the voltage line 20 by a path that sums the base emitter junction voltages of both transistors 28 and 16. Thus, the voltage of the left hand branch at the collector of transistor 2 is held at one base-emitter drop below the voltage line, while the voltage of the right hand branch is held at two base-emitter voltage drops below the same line. This difference in voltages causes differences in currents in each branch and appears as an unwanted offset voltage.

Another prior art attempt to reduce the input voltage offset while simultaneously having high gain is shown in Figure 3, in which elements corresponding to those of Figure 2 are again identified by the same reference numerals. This circuit is similar to that of Figure 2, with the exception that line 24 is replaced by transistor 30. The emitter of transistor 30 is connected to the bases of transistors 12 and 14, while its base is connected to node 7. Also, a resistor 13 connects the bases of transistors 12 and 14 to voltage line 20 while a resistor 15 replaces current source 26. The value of resistor 13 divided into one diode drop is the current through resistor 13, and when added to the base currents of transistors 12 and 14 is the current through transistor 30. Similarly, the value of resistor 15 divided into one diode drop is the current through resistor 15 and, when added to the base current of transistor 16, is the current through transistor 28.

In this configuration, the base current added by transistors 30 and 28 to the left and right hand branches respectively is about the inverse of the second power of transistor current gain. This follows from the fact that the base current of transistors 12 and 14 are in the order of the inverse of the first power of transistor current gain, and those currents are again reduced in proportion to transistor current gain to derive the base current of transistor 30. Similar reasoning is applied to the right hand branch. Although the currents in each branch can approach each other and hence the differential amplifier can have low offset voltage, the mismatch of resistors 13 and 15 causes different currents to flow through transistors 28 and 30, resulting in higher than expected offset voltage. Resistors 13 and 15 are constructed as base pinch resistors and consequently do not match well. Another more severe problem arises with this configuration — the pole at node 7 occurs at a much lower frequency, since the impedance at node 7 is raised by the addition of transistor 30. Consequently, the bandwidth of the differential amplifier is greatly reduced.

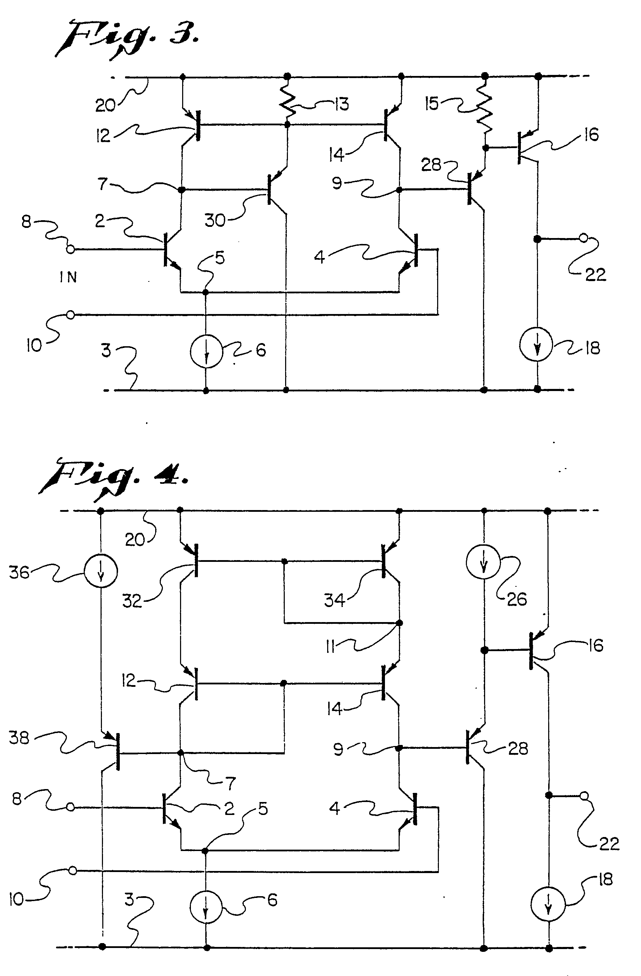

Referring now to Figure 4, another prior art circuit is shown which has been found to have the highest differential amplifier gain when compared to the circuits of Figs. 1, 2 or 3. This circuit is similar to that of Figure 2, and its corresponding elements are identified by the same reference numerals. In addition, a pair of transistors 32 and 34 have been added to the load circuit. The emitter-collector of transistor 32 is connected between voltage line 20 and the emitter of transistor 12, while its base is connected in common with that of transistor 34. Also the emitter-collector of transistor 34 is connected between voltage line 20 and the emitter of transistor 14. The base and collector of transistor 34 are connected in common with the emitter of transistor 14 at node 11. This arrangement of transistors 12, 14, 32 and 34 is known as a Wilson current source and has high output impedance. To compensate for the base current of transistor 28, transistor 38 is added with its base at node 7, its collector connected to line 3 and its emitter connected to current source 36, whose current is equal to that of current source 26. Although differential amplifier gain is increased and the offset voltage kept low, the pole at node 7 approaches that of Figure 3, and hence the bandwidth is greatly reduced. The circuit of Figure 4 is more complex, and consumes more power. For Figures 3 and 4, the magnitude of current in each branch of the differential amplifier differs by a value that is proportional to the inverse of the second power of PNP transistor current gain. The value of PNP transistor current gain is usually much lower than that of the NPN transistor in an integrated circuit. Therefore, the offset voltages for Figures 3 and 4 are significantly high.

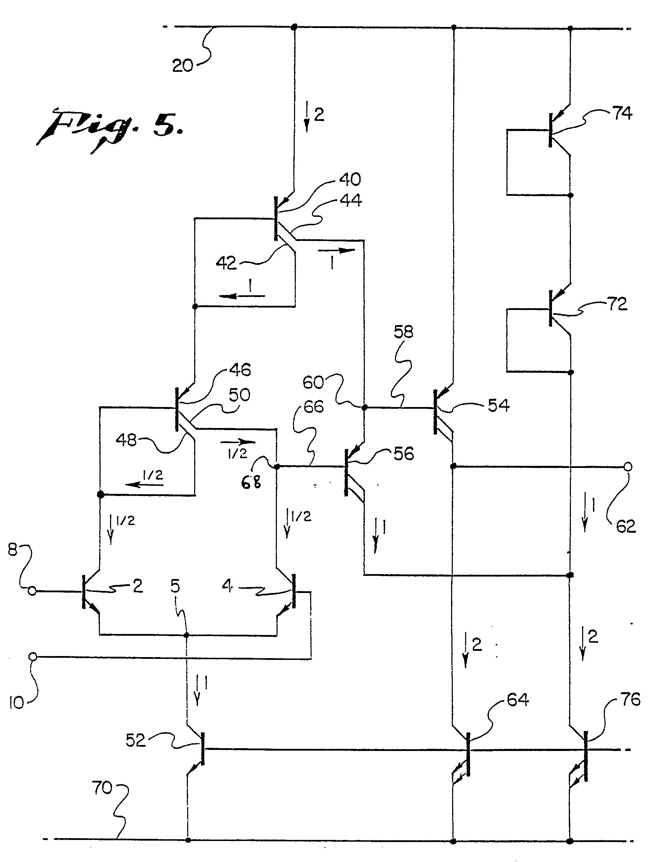

A circuit constructed in accordance with the present invention is shown in Figure 5. In the embodiment shown, a primary load circuit provides load currents to the first and second amplifier branch transistors 2 and 4, while a secondary load circuit provides a balancing current to branch transistor 4.

The primary load circuit consists of a first current mirror comprising a first PNP transistor 40 with matched dual collectors 42 and 44. Its emitter is connected to positive voltage supply line 20, while its collector 42 is connected to its base and to a second current mirror comprising a second PNP transistor 46 with matched dual collectors 48 and 50. The emitter of transistor 46 is connected to the base and collector 42 of transistor 40. Its collector 48 is connected in common with its base to supply current to the collector of branch transistor 2, while its other collector 50 is connected to supply current to the collector of the other branch transistor 4. The emitters of amplifier branch transistors 2 and 4 are connected in common with the collector-emitter circuit of a transistor 52, which serves as current source 6 shown in the prior Figures. Biasing for transistor 52 is not shown.

The secondary load circuit includes a pair of junction transistors 54 and 56. Transistor 54, which also functions as a second gain stage, is a dual collector PNP transistor matched with transistor 40. Its emitter is connected to voltage supply line 20, its base is connected over line 58 to a node 60 which provides a junction between the emitter of transistor 56 and the collector 44 of transistor 40, and its dual collectors are connected in common to an output terminal 62 and to the collector of an NPN current source transistor 64. The latter transistor has a dual emitter, and is mirrored and matched with transistor 52 to draw twice as much current as that transistor.

Transistor 56 is also a dual collector PNP transistor, matched with transistor 46. Its base is connected over line 66 to a node 68 which provides a junction between collector 50 of transistor 46 and the collector of branch transistor 4. The dual collectors of transistor 56 could be connected to the negative voltage line 70, but preferably are connected instead to positive voltage supply line 20 through a voltage clamping circuit consisting of a pair of diode-connected junction transistors 72 and 74, connected in series. The dual collectors of transistor 56 are also connected to the negative voltage line 70 through another dual emitter current source transistor 76, which is matched and mirrored with current source transistor 64.

The operation of the circuit will now be described, with relative values of the currents through the various transistors indicated by the numbers next to the current flow arrows in Figure 5. These current values ignore the effects of base currents, which will be discussed hereinafter. Assuming that current source transistor 52 draws unity current, then the total emitter-collector currents of transistors 40 and 54 will each be 2, the total emitter-collector currents of transistors 46, 56, 72, and 74 will each be 1, and the collector-emitter currents of amplifier branch transistors 2 and 4 will each be ½.

By the definition of transistor current gain, the base current of each transistor is equal to its collector current multiplied by the inverse of the first power of transistor current gain. Thus, the base current of transistor 40 will be proportional to an inverse first power of current gain. This base current is added to the current from collector 42 of transistor 40, and produces an emitter current for transistor 46 which has components proportional to the zero and inverse of the first power of current gain. This input current is again divided by a factor of transistor current gain to produce a base current for transistor 46 which has components proportional to the inverse of the first and second power of current gain, while the currents in collectors 48 and 50 of transistor 46 each have components proportional to the zero and inverse of the first power of current gain. The primary currents delivered by the collectors of transistor 46 to branch transistors 2 and 4 are thus unbalanced by an amount which is proportional to the inverse of the first and second power of transistor current gain.

In the secondary load circuit, the emitter current of transistor 54 is proportional to a zero power of transistor current gain; accordingly, its base current is proportional to the inverse of the first power of current gain. This base current is supplied together with the current from collector 44 of transistor 40 to the emitter of transistor 56, and produces a base current in that transistor having components proportional to the inverse of the first and second power of current gain. since transistor 40 is matched with transistor 54, and transistor 46 is matched with transistor 56, the base current supplied to the right hand amplifier branch from transistor 56 places the currents through the two amplifier branch transistors 2 and 4 substantially in balance, differing only by an amount proportional to about the inverse of the third power of transistor current gain.

Voltage imbalances between the two amplifier branches are also greatly reduced by the improved load circuit. The left hand amplifier branch comprising transistor 2 is clamped to positive voltage supply line 20 through the double junction path formed by the base-emitter junctions of transistors 46 and 40, while the right hand amplifier branch comprising transistor 4 is clamped to positive voltage supply line 20 through the double junction path formed by the base-emitter junctions of transistors 54 and 56. Since corresponding transistors in the primary and secondary load circuits are matched, and the currents driven through the transistors are also matched, both amplifier branches are clamped at substantially equal voltage drops below the supply level. Also, the clamping of the dual collectors of transistor 56 through diode-connected transistors 72 and 74 substantially eliminates any unbalance which would otherwise result from the finite output impedance of transistor 56.

With the circuit as shown, the voltage offset at input terminals 8 and 10 is proportional to the natural logarithm of $(1 + 16/\beta^3)$, where $\beta$ is the transistor current gain. This represents a distinct improvement over the voltage offsets produced by the prior art circuits described previously, in which the voltage offset is reduced to no more than a natural logarithmic function of $(1/\beta^2)$. The improvement in input voltage offset is not achieved by sacrificing either amplifier gain or bandwidth. Gain is at least as high as in the prior art devices, and the avoidance of additional mirror poles permits the retention of a bandwidth of about 1 MHz typical of current general purpose operational amplifiers with only one mirror pole. Furthermore, the circuit design is quite simple, making it feasible to manufacture at a competitive price.

While details of a particular embodiment of the invention have been described, various modifications could be made within the scope of the invention. For example, the polarity of the transistors could be reversed, and the accompanying circuitry and directions of current flow adjusted accordingly.

## Claims

1. A differential amplifier circuit, with a precision active load for correcting input voltage offsets, comprising:

a differential amplifier having first and second input means (8, 10) connected respectively to first and second amplifier branches (2, 4);

a primary load circuit connected to a voltage supply (20) and including at least a first and a second transistor means (40, 46) connected to provide primary load currents respectively to said first and second amplifier branches; and

a secondary load circuit connected to the voltage source and to the second amplifier branch, characterised in that

said primary load currents are mutually unbalanced by a current having components proportional to the inverse of the first and second power of transistor current gain, said primary load circuit providing a multi-junction path between the voltage source and the first amplifier branch to clamp the voltage level of said branch with respect to the source;

and in that said secondary load circuit is connected to the voltage source and to the second amplifier branch to substantially balance the currents in the two amplifier branches, said secondary load circuit including at least a third and fourth transistor means (54, 56) matched with the respective first and second transistor (40, 46) means of the primary load circuit, and connected to provide a balancing current having components proportional to the inverse of the first and second power of transistor current gain to the second amplifier branch, said secondary load circuit being further connected to provide a multi-junction path between the voltage source and the second amplifier branch to substantially balance the voltage levels of the two amplifier branches, whereby the input voltage offset is a function of no more than the inverse of the third power of transistor current gain.

2. The differential amplifier circuit of claim 1, said primary load circuit comprising first (40) and second (46) current mirror means, the first (40) current mirror means connected to provide to the second (46) current mirror means a current having components proportional to the zero and inverse first power of transistor current gain, and the second (46) current mirror means comprising a transistor (46) means having matched dual terminals (48, 50) connected to provide said primary load currents to the first and second amplifier branches (2, 4) respectively.

3. The differential amplifier circuit of claim 2, said secondary load circuit including first (44) and second (54) means for providing first and second currents matched respectively with the zero and inverse first power components of the first (40) current mirror content, third means (56) responsive to said first and second currents for providing a balancing current matched with the inverse first and second power of gain components of the current provided by the second (46) current mirror means, and means (66) for combining said balancing current with the current provided by the second current mirror means to the second amplifier branch.

4. The differential amplifier circuit of claim 3, the second means of the secondary load circuit comprising a third transistor means (54) having a base circuit (58) and a collector-emitter circuit, and means (64) for supplying a collector-emitter current to said junction transistor means (54) of sufficient magnitude so that its base current is matched with the inverse first power of gain current component provided by the first current mirror means (40).

5. The differential amplifier circuit of claim 3, wherein the first current mirror means (40) comprises a transistor means (40) having matched dual terminals (44, 42) and a base terminal, one of its dual terminals (42) being connected together with the base terminal to provide current to the second current mirror means (46), and the other of the dual terminals (44) being connected to provide the first current of the secondary circuit.

6. The differential amplifier circuit of claim 1, including current source means (52, 64, 76) connected to direct currents through the first (40), second (46), third (54) and fourth (56) transistor means such that the voltage drop across the double junction path formed by the first and second transistor means substantially equals the voltage drop across the double junction path formed by the third and fourth transistor means.

**Patentansprüche**

1. Differentialverstärkerschaltung, mit einer aktiven Präzisionslast zum Korrigieren von Eingangs-Offset-Spannungen, mit einem Differentialverstärker, der einen ersten und einen zweiten Eingang (8, 10) aufweist, die an einen ersten bzw. einen zweiten Verstärkerzweig (2, 4) angeschlossen sind, mit einer Primär-Lastschaltung, die an eine Spannungsquelle angeschlossen ist und mindestens eine erste und eine zweite Transistorschaltung (40, 46) aufweist, die derart verschaltet ist, daß sie dem ersten bzw. dem zweiten Verstärkerzweig Primär-Lastströme zuführen, und mit einer Sekundär-Lastschaltung, die an die Spannungsquelle und an den zweiten Verstärkerzweig angeschlossen ist, dadurch gekennzeichnet, daß die Primär-Lastströme durch einen Strom in bezug aufeinander unsymmetrisch gemacht werden, der Komponenten aufweist, die proportional zu dem Inversen der ersten und der zweiten Potenz der Transistorstromverstärkung sind, wobei die Primär-Lastschaltung einen Mehrfachverbindungsweg zwischen der Spannungsquelle und dem ersten Verstärkerzweig bildet, um den Spannungspegel des Zweiges in bezug auf die Quelle zu klemmen, und daß die Sekundär-Lastschaltung an die Spannungsquelle und an den zweiten Verstärkerzweig angeschlossen ist, um die Ströme in den zwei Verstärkerzweigen im wesentlichen zu symmetrieren, wozu die Sekundär-Lastschaltung mindestens eine dritte und eine vierte Transistorschaltung (54, 56) aufweist, die an die erste bzw. die zweite Transistorschaltung (40, 46) der Primär-Lastschaltung angepaßt sind, und die derart verschaltet sind, daß sie einen Symmetrierstrom an den zweiten Verstärkerzweig liefern, dessen Komponenten proportional zu dem Inversen der ersten und der zweiten Potenz der Transistorstromverstärkung sind, und die Sekundär-Lastschaltung außerdem derart verschaltet ist, daß sie einen Mehrfachverbindungsweg zwischen der Spannungsquelle und dem zweiten Verstärkerzweig schafft, um die Spannungspegel der zwei Verstärkerzweige im wesentlichen auszugleichen, wodurch die Eingangs-Offset-Spannung eine Funktion von nicht mehr als dem Inversen der dritten Potenz der Transistorstromverstärkung ist.

2. Differentialverstärkerschaltung nach Anspruch 1, dadurch gekennzeichnet, daß die Primär-Lastschaltung eine erste (40) und eine zweite (46) Stromspiegeleinrichtung aufweist, daß die erste (40) Stromspiegeleinrichtung derart verschaltet ist, daß sie an die zweite (46) Stromspiegeleinrichtung einen Strom liefert, der Komponenten aufweist, die proportional zu der nullten und der Inversen der ersten Potenz der Transistorstromverstärkung sind, und daß die zweite (46) Stromspiegeleinrichtung eine Transistorschaltung (46) aufweist, die angepaßte Doppelanschlüsse (48, 50) besitzt, die so verschaltet sind, daß sie Primär-Lastströme an den ersten bzw. den zweiten Verstärkerzweig (2, 4) geben.

3. Differentialverstärkerschaltung nach Anspruch 2, dadurch gekennzeichnet, daß die Sekundär-Lastschaltung eine erste (44) und eine zweite (54) Einrichtung besitzt, die einen ersten bzw. einen zweiten angepaßten Strom mit den Komponenten der nullten und der inversen ersten Potenz des ersten (40) Stromspiegelstroms liefert, eine dritte Einrichtung (56) besitzt, die auf den ersten und den zweiten Strom anspricht und einen Symmetrierstrom liefert, der angepaßt ist an die Inverse erste und zweite Potenz der Verstärkung der Komponenten des von der zweiten (46) Stromspiegeleinrichtung gelieferten Stroms, und eine Einrichtung (66) besitzt zum Kombinieren des Symmetrierstroms mit dem von der zweiten Stromspiegeleinrichtung dem zweiten Verstärkerzweig zugeführten Strom.

4. Differentialverstärkerschaltung nach Anspruch 3, dadurch gekennzeichnet, daß die zweite Einrichtung der Skundär-Lastschaltung eine dritte Transistorschaltung (54) mit einem Basiskreis (58) und einem Kollektor-Emitter-Kreis, sowie eine Einrichtung (64) aufweist, die an die Verbindungs-Transistorschaltung (54) einen Kollektor-Emitter-Strom liefert, dessen Stärke ausreichend groß ist, damit ihr Basisstrom an die von der ersten Stromspiegeleinrichtung (40) gelieferte Stromkomponente der inversen ersten Verstärkungspotenz angepaßt ist.

5. Differentialverstärkerschaltung nach Anspruch 3, dadurch gekennzeichnet, daß die erste Stromspiegeleinrichtung (40) eine Transistorschaltung (40) mit angepaßten Doppelanschlüssen (44, 42) und einem Basisanschluß aufweist, daß einer der Doppelanschlüsse (42) mit dem Basisanschluß gekoppelt ist, um der zweiten Stromspiegeleinrichtung (46) Strom zuzuführen, und daß der andere Doppelanschluß (44) derart verschaltet ist, daß er den ersten Strom der Sekundär-Schaltung liefert.

6. Differentialverstärkerschaltung nach Anspruch 1, gekennzeichnet durch eine Stromquellenschaltung (52, 64, 76), die derart verschaltet ist, daß sie Ströme durch die erste (40), die zweite (46), die dritte (54) und die vierte (56) Transistorschaltung leitet, so daß der Spannungsabfall an dem Doppel-Verbindungsweg, der durch die erste und die zweite Transistorschaltung gebildet wird, etwa dem Spannungsabfall gleicht, der an dem durch die dritte und die vierte Transistorschaltung gebildeten Doppel-Verbindungsweg erfolgt.

**Revendications**

1. Circuit amplificateur différentiel, ayant une charge active réglée avec précision, destinée à corriger les décalages des tensions d'entrée, comprenant:
un amplificateur différentiel ayant une première et une seconde entrée (8, 10) connectèes respectivement à une première et une seconde branche de l'amplificateur (2, 4),
un circuit primaire de charge connecté à une source de tension (20) et comprenant au moins un premier et un second transistor (40, 46) connectés afin qu'ils transmettent des courants primaires de charge respectivement à la première et à la seconde branches de l'amplificateur, et
un circuit secondaire de charge connecté à la source de tension et à la seconde branche de l'amplificateur,
caractérisé en ce que:
les courants primaires de charge sont mutuellement déséquilibrés par un courant ayant des composantes proportionnelles à l'inverse de la première et de la seconde puissance du gain en courant du transistor, le circuit primaire de charge formant un trajet à plusieurs jonctions entre la source de tension et la première branche de l'amplificateur afin que le niveau de tension de cette branche soit écrêté par rapport à la source, et
en ce que le circuit secondaire de charge est connecté à la source de tension et à la seconde branche de l'amplificateur afin qu'il équilibre pratiquement les courants dans les deux branches de l'amplificateur, le circuit secondaire de charge comprenant au moins un troisième et un quatrième transistor (54, 56) qui sont adaptés respectivement avec le premier et le second transistor (40, 46) du circuit primaire de charge, et qui sont connectés afin qu'ils créent un courant d'équilibrage ayant des composantes proportionnelles à l'inverse de la première et de la seconde puissance du gain en courant du transistor à la seconde branche de l'amplificateur, le circuit secondaire de charge étant en outre connecté afin qu'il forme un trajet à plusieurs jonctions entre la source de tension et la seconde branche de l'amplificateur et équilibre pratiquement les niveaux de tension des deux branches de l'amplificateur, si bien que la tension de décalage d'entrée est fonction au plus de l'inverse de la troisième puissance du gain en courant du transistor.

2. Circuit amplificateur différentiel selon la revendication 1, le circuit primaire de charge comprenant un premier (40) et un second (46) miroir de courant, le premier miroir de courant (40) étant connecté afin qu'il transmettre au second miroir de courant (46) un courant ayant des composantes proportionnelles à la racine et à l'inverse de la première puissance du gain en courant du transistor, et le second miroir de courant (46) comprenant un transistor (46) ayant des bornes doubles adaptées (48, 50) connectées afin qu'elles transmettent les les courants primaires de charge à la première et à la seconde branche de l'amplificateur (2, 4) respectivement.

3. Circuit amplificateur différentiel selon la revendication 2, le circuit secondaire de charge comprenant un premier et un second dispositif (44, 54) destinés à transmettre les premier et second courant adaptés respectivement aux composantes de la racine et de l'inverse de la première puissance du courant du premier miroir de courant (40), un troisième dispositif (56) commandé par le premier et le second courant et destiné à former un courant d'équilibrage adapté aux composantes de l'inverse de la première et de la seconde puissance du gain du courant transmis par le second miroir de courant (46), et un dispositif (66) de combinaison du courant d'équilibrage avec le courant transmis par le second miroir de courant à la seconde branche de l'amplificateur.

4. Circuit amplificateur différentiel selon la revendication 3, le second dispositif du circuit secondaire de charge comprenant un troisième transistor (54) ayant un circuit de base (58) et un circuit collecteur-émetteur, et un dispositif (64) destiné à transmettre un courant collecteur-émetteur au transistor à jonction (54) avec une intensité suffisante pour que son courant de base soit adapté à la composante de l'inverse de la première puissance du gain en courant, transmise par le premier miroir de courant (40).

5. Circuit amplificateur différentiel selon la revendication 3, dans lequel le premier miroir de courant (40) est un transistor (40) ayant des bornes doubles adaptées (44, 42) et une borne de base, l'une de ces bornes doubles (42) étant connectée à la borne de base afin qu'elle transmette un courant au second miroir de courant (46) et l'autre des bornes doubles (44) étant connectée afin qu'elle transmette le premier courant du circuit secondaire.

6. Circuit amplificateur différentiel selon la revendication 1, comprenant une source de sourant (52, 64, 76) connectée de manière qu'elle dirige des courants dans le premier (40), le second (46), le troisième (54) et le quatrième (56) transistor afin que la chute de tension aux bornes du trajet à deux jonctions formé par le premier et le second transistor soit sensiblement égale à la chute de tension dans le trajet à deux jonctions formé par le troisième et le quatrième transistor.

*Fig. 1.*

*Fig. 2.*

1

# Fig. 3.

# Fig. 4.

Fig. 5.